# EUROPEAN PATENT SPECIFICATION

(11) **EP 0 789 387 B1**
(45) Date of publication and mention of the grant of the patent: **21.11.2001**
(21) Application number: 96927199.8
(22) Date of filing: 20.08.1996
(51) Int. Cl.: H01L 21/28

(54) **LAMINATE AND PROCESS FOR FORMING OHMIC ELECTRODE**
LAMINAT UND VERFAHREN FÜR DIE HERSTELLUNG EINER OHMSCHEN ELEKTRODE
LAMINE ET PROCEDE PERMETTANT DE FORMER UNE ELECTRODE OHMIQUE

(30) Priority: 24.08.1995 JP 23912095
(43) Date of publication of application: 13.08.1997
(73) Proprietor: SONY CORPORATION, Tokyo 141 (JP)
(72) Inventor: NAKAMURA, Mitsuhiro-Sony Corporation, Tokyo 141 (JP); WADA, Masura-Sony Corporation, Tokyo 141 (JP); UCHIBORI, Chihiro-Dept. of Metal Scie. and Techn., Sakyo-ku, Kyoto-shi,Kyoto (JP); MURAKAMI, Masanori-Dep. of Metal Scie. andTechn., Sakyo-ku, Kyoto-shi, Kyoto (JP)
(74) Representative: Müller, Frithjof E., Dipl.-Ing.
(86) International application number: JP9602318
(87) International publication number: WO9708744

(56) References cited:
- JP-A- 1 166 556
- JP-A- 6 267 887
- JP-A- 7 094 444
- US-A- 4 833 042
- US-A- 5 027 187
- US-A- 5 089 438
- IEEE ELECTRON DEVICE LETTERS, vol. EDL-6, no. 8, August 1985, NEW YORK US, pages 437-438, XP002033693 R.D. REMBA ET AL.: "Use of a TiN barrier to improve GaAs FET ohmic contact reliability"
- JOURNAL OF APPLIED PHYSICS, vol. 68, no. 5, 1 September 1990, pages 2475-2481, XP000108786 KIM H -J ET AL: "THERMALLY STABLE OHMIC CONTACTS TO N-TYPE GAAS. VIII SPUTTER-DEPOSITED INAS CONTACTS"
- PATENT ABSTRACTS OF JAPAN, vol. 17, no. (E-827) , & JP 1 166556 A

## Description

### Technical Field

This invention relates to a multi-layered structure for fabricating an ohmic electrode and an ohmic electrode suitable for, in particular, III-V compound semiconductors.

### Background Art

Decrease in contact resistance of ohmic electrodes and improvement of their thermal stability are important issues for implementation of high performance and reliability of devices such as FETs using compound semiconductors. So far, however, no satisfactory ohmic electrodes are available for compound semiconductors, in particular, GaAs or other III-V compound semiconductors.

At present, the most frequently used material of ohmic electrodes for GaAs semiconductors is AuGe/Ni. The use of AuGe/Ni as the material of ohmic electrodes makes it possible to fabricate ohmic electrodes in ohmic contact with GaAs semiconductors by annealing at 400 to 500°C.

The most serious problem with the use of AuGe/Ni as the material of ohmic electrodes is that the thermal instability of the ohmic electrodes fabricated with the material. That is, since AuGe/Ni contains a great amount of Au (88% of typically used AuGe), Au reacts with GaAs at a temperature of or above 400°C, and makes β-AuGa (of a hexagonal close packed (HCP) structure with melting point Tₘ=375°C), which causes deterioration of the thermal stability even though contributing to a decrease in contact resistance of the ohmic electrode. It results in inviting deterioration of device characteristics due to high temperature processes such as chemical vapor deposition (CVD) executed after formation of the ohmic electrode.

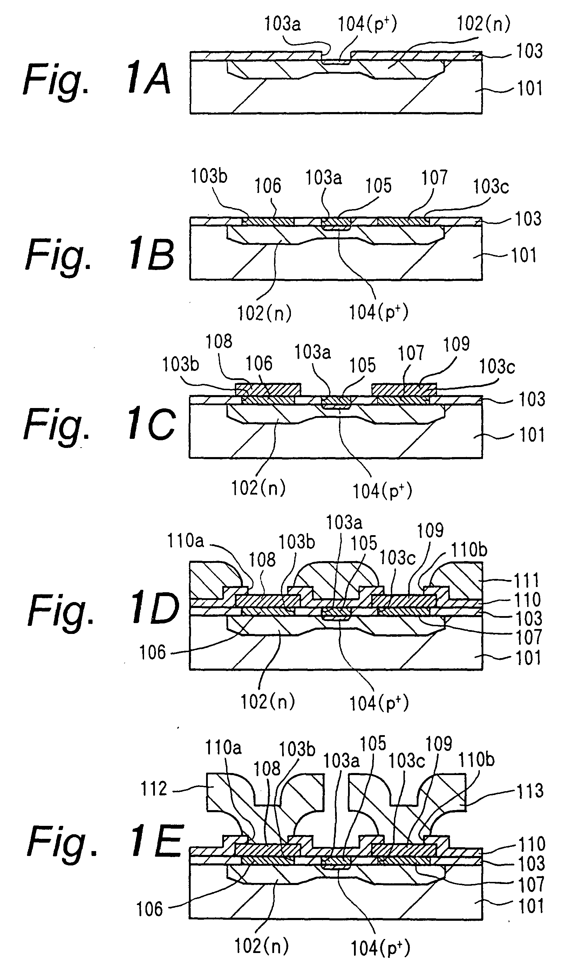

This problem is explained below by taking a specific JFET manufacturing process with reference to Fig. 1. That is, in this manufacturing process, an n-type channel layer 102 is first formed in a semi-insulating GaAs substrate 101 as shown in Fig. 1A by selective ion implantation of an n-type impurity and subsequent annealing. Then, an insulating film 103, such as Si₃N₄ film, is deposited on the entire surface of the semi-insulating GaAs substrate 101, and selectively removed by etching to form an opening 103a. After that, a p-type impurity, Zn, is diffused into the n-type channel layer 102 through the opening 103a to make a p⁺-type gate region 104. Next, for example, a Ti/Pt/Au film is deposited on the entire surface as a material for the gate electrode. After that, a resist pattern (not shown) having a shape corresponding to the gate electrode is formed on the Ti/Pt/Au film. Next, the Ti/Pt/Au film is patterned by an ion milling method using the resist pattern as a mask. As a result, the gate electrode 105 is formed as shown in Fig. 1B. Next, after the insulating film 103 is selectively removed by etching to make openings 103b, 103c, ohmic electrodes 106, 107 as the source electrode and the drain electrode, respectively, are fabricated on the n-type channel layer 102 accessed through the openings 103b, 103c by using AuGe/Ni as their material. Next, as shown in Fig. 1C, first-layer wirings 108, 109 respectively coupled to the ohmic electrodes 106, 107 are made. Next, as shown in Fig. 1D, an inter-layer insulating film 110, such as Si₃N₄ film, is deposited by a CVD method on the entire surface to provide electrical insulation from second-layer wiring, referred to later, and selectively removed by etching to make openings 110a, 110b. A high temperature near 400°C is applied in this step of depositing the inter-layer insulating film 110 by a CVD method, and deteriorates the device characteristics. To make the second-layer wiring, a resist 111, for example, is applied to the surface except for areas for contacts of the second-layer wiring. After a material for the second-layer wiring is applied on the entire surface, the resist 111 is removed. As a result, second-layer wirings 112, 113 are obtained in the form of air bridge wiring as shown in Fig. 1E.

Apart from the above-indicated problem, the use of AuGe/Ni as the material of the ohmic electrode causes β-AuGa produced by reaction between GaAs and Au. β-AuGa coarsens the surface of the ohmic electrode and makes subsequent fine working difficult.

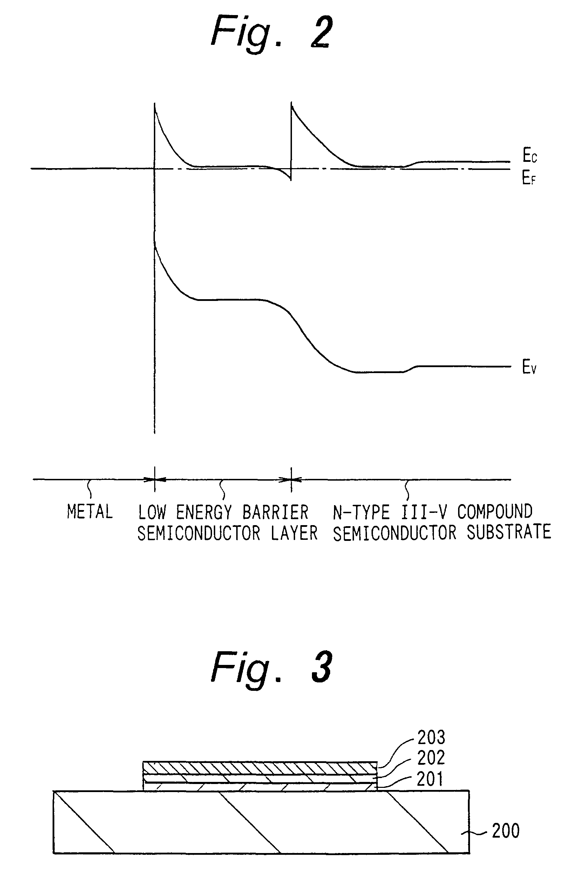

Studies have so far been made on various materials for ohmic electrodes to overcome these problems. The most ideal approach from the viewpoint of ohmic contact is to establish ohmic contact by using metal which lowers the energy barrier at the interface with an electrode metal and does not contain a compound with a low melting point, such as β-AuGa, as shown in Fig. 2 in which E_{c} and Eᵥ are bottom and top energies of the conduction band, and E_{F} the Fermi energy. This structure of ohmic electrode shown in Fig. 2 is obtained by epitaxially growing an InₓGa₁₋ₓAs layer as an intermediate layer with a low energy barrier on a GaAs substrate by a metallorganic chemical vapor deposition (MOCVD) method, for example, and by providing an electrode metal on the layer. However, the use of an epitaxial growth equipment, such as MOCVD apparatus, to make the structure of ohmic electrode reduces the process window and degrades the mass productivity.

There is a report, directed to solution of these problems, which proposes to make on a GaAs substrate a multi-layered structure, such as InAs/W, InAs/Ni/W, Ni/InAs/Ni/W, and so forth, by depositing the intermediate InAs layer with a low energy barrier by a sputtering method using InAs as the target and by depositing the W and Ni films by an electron beam evaporation method and to apply subsequent annealing, which is said to result in obtaining an ohmic electrode having a good thermal stability (J. Appl. Phys. 68, 2475(1990)). Fig. 3 shows one of such examples in which the ohmic electrode is fabricated by depositing an InAs layer 201 on an n-type GaAs substrate 200 by a sputtering method, then depositing a Ni film 202 and a W film 203 sequentially on the InAs layer 201, and later annealing the structure.

This method is quite excellent in mass productivity because of using a sputtering method which can make the InAs layer 201 at a high speed. In addition, since the ohmic electrode uses the W film 203 which is a refractory metal as its top layer, which permits any kind of metals like Al, Au, and so on, to be used as the material of metallization for connection to the ohmic electrode without using a barrier metal, the design allows a wide choice in the process sequence. Nevertheless, this method still involves the serious problem that diffusion of a slight amount of In on the W film 203 during annealing, disturbs realization of a sufficiently low contact resistance. There is also an additional problem that diffusion of In on the W film 203 during annealing coarsens the surface of the ohmic electrode and significantly degrades its morphology.

In recent years, to solve the problem of the surface morphology of the ohmic electrode, the present Applicant proposed a method for fabricating an ohmic electrode in which a multi-layered structure of InAs/Ni/WSi/W is formed on a GaAs substrate and then annealed (Japanese Patent Laid Open Publication No. Hei 7-94444). However, the ohmic electrode formed by the method has a problem that the contact resistance is high as compared with the conventional ohmic electrode fabricated using AuGe/Ni. There is also a problem that diffusion of impurity is easy to occur during annealing and redistribution of impurity is caused since annealing temperature necessary to fabricate the ohmic electrode is 700°C to 800°C which is high. This will cause a problem when a base layer of high impurity concentration is formed in the narrow area in a bipolar transistor, for example.

Only having existing ohmic electrodes with unsatisfactory property for use on GaAs semiconductors, realization of an ohmic electrodes with practically satisfactory characteristics has been waited for.

Patent Abstracts of Japan, vol. 17 (E-827) & JP-A-1 166 556 disclose an n-type GaAs ohmic electrode and formation thereof, including a multi-layered structure suitable for fabricating an ohmic electrode and comprising a semiconductor layer and a film which includes as one alternative a high melting point metal nitride layer, which layers are sequentially stacked on a III-V compound semiconductor body. A step in the formation of the ohmic electrode includes heat treatment to form an ohmic electrode on the III-V compound semiconductor body.

IEEE Electron Device Letters, vol. EDL-6, No. 8 (August 1985), New York, US, pages 437-438, XP002033693; R.D. Remba et al.: "Use of a TiN barrier to improve GaAs FET ohmic contact reliability" relates to the properties of a TiN barrier layer between a GaAs(Ni)GeAuPt-alloy and a Ti/Pt/Au overlay, wherein an ohmic electrode is formed from a non-multi-layered structure layer stack comprising a Ge layer and a TiN layer.

### Disclosure of the Invention

It is therefore an object of the invention to provide a multi-layered structure with which ohmic electrodes having practically satisfactory characteristics for GaAs semiconductors and other III-V compound semiconductors can be easily fabricated, and an ohmic electrode obtained by using it.

According to the present invention, this object is accomplished by a multi-layered structure as defined in claim 1, and by a method of fabricating an ohmic electrode as defined in claim 10.

Advantageous further developments of the invention are subject of the accompanying dependent claims.

Hence, a multi-layered structure for fabricating an ohmic electrode according to the invention, comprises a non-single crystal semiconductor layer and a film including at least a metal nitride film which are sequentially stacked on a III-V compound semiconductor body.

Further, a multi-layered structure for fabricating an ohmic electrode according to the invention, comprises a non-single crystal semiconductor layer and a film including at least a metal nitride film which are sequentially stacked on a III-V compound semiconductor body, the energy barrier between the non-single crystal semiconductor layer and the film being lower than the energy barrier between the III-V compound semiconductor body and the film.

An ohmic electrode according to the invention is obtained by annealing a multi-layered structure for fabricating an ohmic electrode, comprising a non-single crystal semiconductor layer and a film including at least a metal nitride film which are sequentially stacked on a III-V compound semiconductor body.

Further, an ohmic electrode according to the invention is an ohmic electrode provided on a III-V compound semiconductor body which is obtained by annealing a multi-layered structure for fabricating an ohmic electrode, comprising a non-single crystal semiconductor layer and a film including at least a metal nitride film,
the energy barrier between said non-single crystal semiconductor layer and said film being lower than the energy barrier between said III-V compound semiconductor body and said film.

In the invention, the III-V compound semiconductor body may be a substrate or a layer composed of, for example, GaAs, AlGaAs or InGaAs. If the III-V compound semiconductor body is of an n-type, it includes, for example, Si, Ge, Te or Sn as a donor impurity. The donor impurity is introduced into the III-V compound semiconductor body by, for example, ion implantation, liquid phase epitaxy (LPE), molecular beam epitaxy (MBE) or metallorganic vapor phase epitaxy (MOVPE).

The non-single crystal semiconductor layer may be a non-single crystal InAs layer or a non-single crystal InₓGa₁₋ₓAs layer (o<x≦1). The term "non-single crystal" herein pertains to polycrystalline or amorphous materials other than single crystal materials. The non-single crystal semiconductor layer is preferably made by a sputtering method, but may also be made by another method such as a vacuum evaporation method, in particular, an electron beam evaporation method. When the non-single crystal semiconductor layer is made by a sputtering method, either a normal sputtering method using a single target of the same semiconductor material as that of the non-single crystal semiconductor layer, or a co-sputtering method using a plurality of targets containing respective elements of the non-single crystal semiconductor layer may be employed.

A metal film, such as Ni film, may be provided between the III-V compound semiconductor body and the non-single crystal semiconductor layer for the purpose, among others, of improving the affinity of the non-single crystal semiconductor layer to the III-V compound semiconductor body.

In one typical embodiment of the invention, the film on the non-single crystal semiconductor layer comprises a metal film and a metal nitride film provided on the metal film. In this case, the metal film is used for the purpose, among others, of annealing at a lower temperature to make an ohmic electrode with a low contact resistance. The metal nitride film is used for the purpose of preventing elements constituting the non-single crystal semiconductor layer, e.g. In, from diffusing toward the electrode surface during annealing. For one or other reasons, such as reducing the sheet resistance of the ohmic electrode or permitting metal wiring to be connected to the ohmic electrode without the need for a barrier metal, there is preferably provided, on the metal nitride film, a refractory metal film having a lower resistivity than that of the metal nitride film unlikely to react on a material used for wiring. The metal film may be a Ni film, an Al film or a Co film. The metal nitride film may be a WN film, a WSiN film, a TaN film a TaSiN film, a TiN film a TiSiN film, a TiON film and so on. These metal nitride films may be crystalline (for example, policrystalline) or amorphous. The refractory metal film may be a W film, a Mo film a Ta film and so on.

To reduce the sheet resistance of the ohmic electrode and to make possible to use the ohmic electrode also for wiring, the metal film for wiring, for example, an Al film, an Al alloy (Al-Si, Al-Cu, Al-Si-Cu, and so on) film, an Au film, an Au/Ti film, and so on may be made on the refractory metal film.

The films on the non-single crystal semiconductor layer, i.e. the metal film, the metal nitride film, the refractory metal film, and so on, may be made by a sputtering method or a vacuum evaporation method, in particular, electron beam evaporation method. In case of making these metal film, metal nitride film, and refractory metal film by a sputtering method, either a normal sputtering method using a single target of the same material as that of one of these films, or a co-sputtering method using a plurality of targets containing respective elements constituting one of these films may be employed. In case of making these metal film, metal nitride film and refractory metal film by a vacuum evaporation method, either a single evaporation source comprising the same material as that of one of these films or a plurality of evaporation sources each comprising respective elements constituting one of these films may be used. The refractory metal film may be made by a CVD method in some cases.

According to the invention, an ohmic electrode having practically satisfactory characteristics required in a device, such as thermal stability, low contact resistance, flatness of the surface, and so on, can be easily fabricated by providing the multi-layered structure for fabricating an ohmic electrode, and then annealing at a temperature ranging from 500°C to 600°C. Further, in this case, since annealing temperature necessary to fabricate the ohmic electrode is 500°C to 600°C, which is low-enough, it is possible to prevent diffusion of impurity during annealing and therefore to prevent redistribution of impurity.

### Brief Description of Drawings

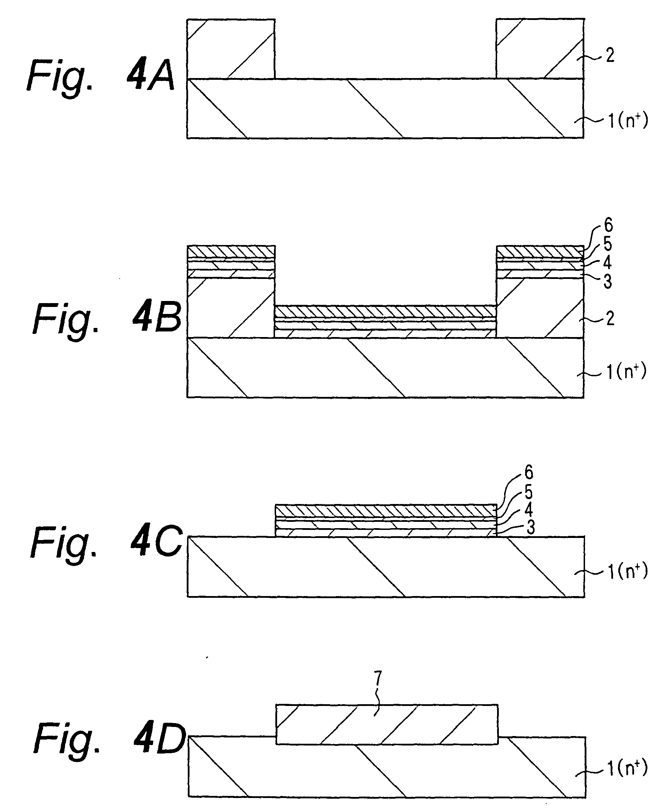

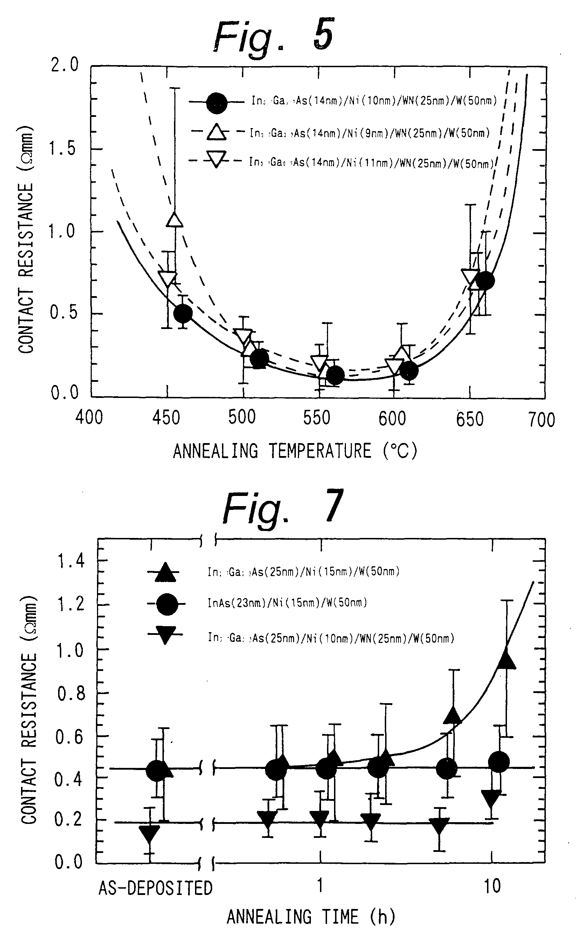

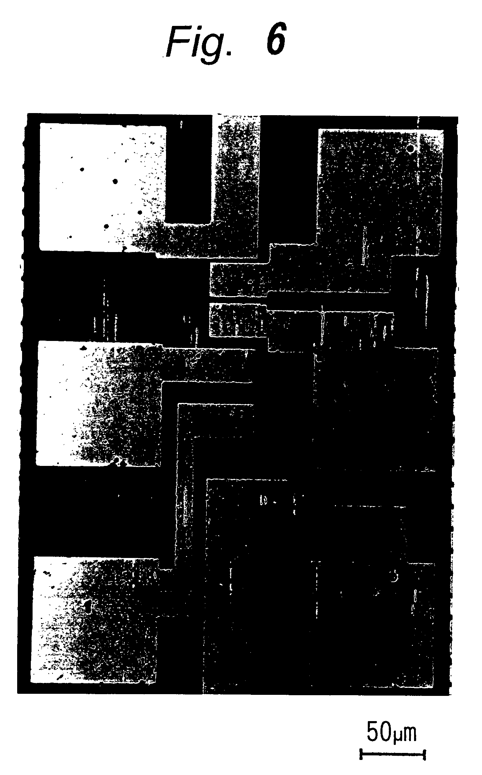

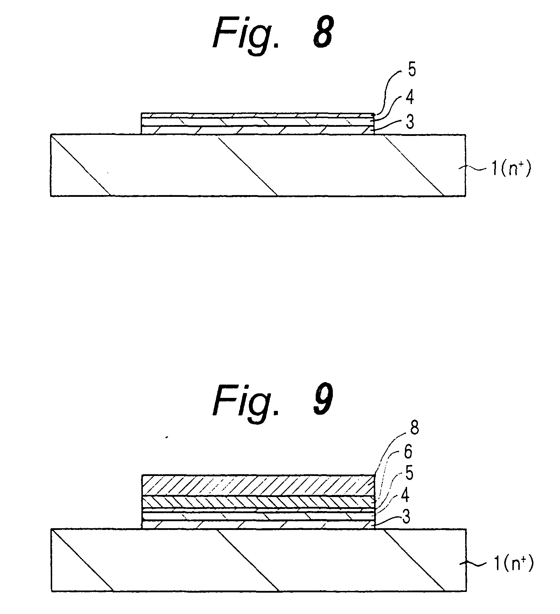

Figs. 1A to 1E are cross-sectional views for explaining problems arising when an existing method for fabricating ohmic electrodes using AuGe/Ni as the ohmic electrode materials is employed for fabricating ohmic electrodes in a GaAs JFET fabricating process; Fig. 2 is an energy band diagram of an ideal ohmic electrode; Fig. 3 is a cross-sectional view of a multi-layered structure for fabricating ohmic electrodes having an InAs/Ni/W structure used in the existing ohmic electrode fabricating method; Figs. 4A to 4D are cross-sectional views for explaining a method for fabricating an ohmic electrode according to a first embodiment of the invention; Fig. 5 is a graph showing changes in contact resistance with annealing temperatures obtained by measurement on ohmic electrodes fabricated by the fabricating method according to the first embodiment; Fig. 6 is an optical micrograph of an ohmic electrode fabricated by making a multi-layered structure for fabricating ohmic electrodes, annealing at 500°C for 1 second and then annealing at 400°C for 10 hours in the fabricating method according to the first embodiment of the invention; Fig. 7 is a graph showing thermal stability obtained by measurement on ohmic electrodes fabricated by the fabricating method according to the first embodiment of the invention; Fig. 8 is a cross-sectional view of a multi-layered structure for fabricating ohmic electrodes used in a method for fabricating ohmic electrodes according to a second embodiment of the invention; Fig. 9 is a cross-sectional view of a multi-layered structure for fabricating ohmic electrodes used in a method for fabricating ohmic electrodes according to a third embodiment of the invention; and Figs. 10A to 10D are cross-sectional views of a multi-layered structure for fabricating ohmic electrodes used in a method for fabricating ohmic electrodes according to a fourth embodiment of the invention.

### Best Mode for Carrying Out the Invention

Embodiments of the invention will now be described with reference to the drawings. In all of the drawings, common or equivalent elements are labelled with common reference numerals.

Fig. 4 shows a process sequence for manufacturing an ohmic electrode according to a first embodiment of the invention.

In the first embodiment, first, as shown in Fig. 4A, a photo resist is applied on an n⁺-type GaAs substrate 1, and then patterned by a photolithography method to make a resist pattern 2 having an opening in the area for the ohmic electrodes to be made. The thickness of the resist pattern 2 is chosen to be sufficiently larger than the total thickness of a non-single crystal In_{0.7}Ga_{0.3}As layer 3, Ni film 4, WN film 5 and W film 6 which are described later. Exposure in the photolithography may use an optical exposure apparatus such as reduced projection exposure apparatus (so-called "stepper"). The resist pattern 2 may also be made by using an electron beam resist and an electron beam lithography method.

Next, as shown in Fig. 4B, a non-single crystal In_{0.7}Ga_{0.3}As layer 3 is deposited on the entire surface by a sputtering method using, for example, In_{0.7}Ga_{0.3}As as the target (for example, magnetron sputtering method), and a Ni film 4, WN film 5 and W film 6 are sequentially deposited on the entire surface by, for example, a sputtering method or an electron beam evaporation method. When a sputtering method such as magnetron sputtering method is used to make the non-single crystal In_{0.7}Ga_{0.3}As layer 3, after evacuating the film making chamber to the base pressure of approximately 2x10⁻⁵ Pa, Ar gas up to the pressure of approximately 3x10⁻¹ Pa is introduced to the chamber and DC-discharged. Power consumed for the discharge is, for example, 150 W. The film making temperature is, for example, room temperature. The film making speed is, for example, 7 nm/minute. When the WN film 5 is made by a sputtering method such as magnetron sputtering method, after evacuating the film making chamber to the base pressure of 2x10⁻⁵ Pa, N₂ gas up to the pressure of approximately 3x10⁻¹ Pa is introduced to the chamber and DC-discharged. Power consumed for the discharge is, for example, 150 W. The film making temperature is, for example, room temperature. Mixed gas combining N₂ gas and Ar gas may be used in lieu of N₂ gas. The sputtering method shown above is a so-called DC sputtering method. A RF sputtering method may be used in lieu of the DC sputtering method.

The n⁺-type GaAs substrate 1 now having on it the non-single crystal In_{0.7}Ga_{0.3}As layer 3, Ni film 4, WN film 5 and W film 6 is immersed in organic solvent, such as acetone, to solubly remove the resist pattern 2, hence causing the non-single crystal In_{0.7}Ga_{0.3}As layer 3, Ni film 4, WN film 5 and W film 6 on the resist pattern 2 to be removed together. As a result, as shown in Fig. 4C, only selective part of the non-single crystal In_{0.7}Ga_{0.3}As layer 3, Ni film 4, WN film 5 and W film 6 in the area corresponding to the opening of the resist pattern 2 remains on the n⁺-type GaAs substrate 1.

The n⁻-type GaAs substrate 1 having these non-single crystal In_{0.7}Ga_{0.3}As layer 3, Ni film 4, WN film 5 and W film 6, i.e. the multi-layered structure for fabricating the ohmic electrode, is then annealed, for example, by RTA (rapid thermal annealing) or by using a typical electric furnace at 500°C to 600°C for a short time, e.g. one second to several minutes. The atmosphere used for the annealing may be composed of N₂ gas with or without an additional small amount of H₂ gas. As a result of the annealing, the ohmic electrode 7 as shown in Fig. 4D is obtained.

Fig. 5 shows a result of measurement on the ohmic electrode 7 made by the method according to the first embodiment of the invention to know the dependency of its contact resistance upon the annealing temperature. Samples were prepared by fixing the thicknesses of the non-single crystal In_{0.7}Ga_{0.3}As layer 3, WN film 5 and W film 6 to 14 nm, 25 nm and 50 nm, respectively, while changing the thickness of the Ni film 4 to three levels of 9 nm, 10 nm and 11 nm, and by making ohmic electrodes by annealing for one second at different temperatures ranging from 450°C to 655°C, using a RTA method. The atmosphere used for the annealing was N₂ gas added with 5% of H₂ gas. n⁺-type GaAs substrates 1 used were prepared by ion implantation into (100)-oriented semi-insulating GaAs substrates to change them to an n-type with the impurity concentration of 2x10¹⁸cm⁻³. Measurement of contact resistances was conducted by TLM (transmission line method). Fig. 5 describes that the contact resistance is lowest at the annealing temperature of 550°C and that a significantly low contact resistance as low as 0.2 Ωmm, approximately, can be obtained.

Fig. 6 is an optical micrograph of the surface of an ohmic electrode 7 made by stacking on an n'-type GaAs substrate 1 a non-single crystal In_{0.7}Ga_{0.3}As layer 3, Ni film 4, WN film 5 and W film 6 to make a multi-layered ohmic electrode structure, then annealing the structure for one second at 550°C by RTA to make the ohmic electrode, and further annealing it for 10 hours at 400°C. Thicknesses of the non-single crystal In_{0.7}Ga_{0.3}As layer 3, Ni film 4, WN film 5 and W film 6 were 14 nm, 20 nm, 25 nm and 25 nm, respectively. Fig. 6 describes that the ohmic electrode 7 after the annealing for 10 hours at 400°C exhibits an excellent surface morphology and an excellent thermal stability. The reason of the good morphology is that the existence of the WN film 5 in the multi-layered structure for fabricating the ohmic electrode prevents dispersion of In from the non-single crystal In_{0.7}Ga_{0.3}As layer 3 toward the surface of the electrode during the annealing.

Changes with time of the ohmic electrode 7, i.e. the thermal stability of the ohmic electrode 7, after the annealing for 10 hours at 400°C after formation, were also measured. Its result was as shown in Fig. 7. Thicknesses of the non-single crystal In_{0.7}Ga_{0.3}As layer 3, Ni film 4, WN film 5 and W film 6 were 25 nm, 10 nm, 25 nm and 50 nm, respectively. Fig. 7 also shows, for the comparison purpose, results of measured thermal stabilities of an ohmic electrode made by using a multi-layered structure for fabricating the ohmic electrode with no WN film included, more specifically, comprising a 15nm-thick Ni film and a 50nm-thick W film stacked on a 25nm-thick non-single crystal In_{0.7}Ga_{0.3}As layer, and an ohmic electrode made by using a multi-layered structure for fabricating the ohmic electrode with a 15nm-thick Ni film and a 50nm-thick W film stacked on a 23nm-thick non-single crystal InAs layer.

Fig. 7 describes that the contact resistance of the ohmic electrode made by using the multi-layered structure for fabricating the ohmic electrode with the 15nm-thick Ni film and the 50nm-thick W film stacked on the 25nm-thick non-single crystal In_{0.7}Ga_{0.3}As layer starts increasing in one hour or so after the annealing is started. The ohmic electrode made by using the multi-layered structure for fabricating the ohmic electrode with the 15nm-thick Ni film and the 50nm-thick W film stacked on the 23nm-thick non-single crystal InAs layer maintains a constant contact resistance even after 10 hours following the start of the annealing, which means a good thermal stability; however, the value of the contact resistance is around 0.45 Qmm which is not sufficiently low. In contrast, the ohmic electrode 7 according to the first embodiment made by using the multi-layered structure for fabricating the ohmic electrode including the WN film maintains a constant contact resistance even after 10 hours following the start of the annealing, which means a good thermal stability, and the value of the contact resistance is as low as 0.2 Ωmm. Reasons of the good thermal stability are the fact that the ohmic electrode 7 does not include compounds with low melting points, such as β-AuGa, which are contained in the ohmic electrode made by using AuGe/Ni and the fact that the WN film 5 prevents dispersion of In from the non-single crystal In_{0.7}Ga_{0.3}As layer 3 toward the surface of the electrode.

In summary, the first embodiment can make an ohmic electrode 7 with low contact resistance, low film resistance, plane surface or good surface morphology, and good thermal stability, by first stacking on the n⁺-type GaAs substrate 1 the non-single crystal In_{0.7}Ga_{0.3}As layer 3, Ni film 4, WN film 5 and W film 6 to form a multi-layered structure for fabricating an ohmic electrode, and then annealing it for one second, for example, at 500°C to 600°C by a RTA method, for example. The ohmic electrode 7 has an energy band structure close to the ideal energy band structure shown in Fig. 2. The ohmic electrode 7 permits direct connection of metal wiring without using a barrier metal because it includes W with a high melting point on its top surface. The non-single crystal In_{0.7}Ga_{0.3}As layer 3 used to make the ohmic electrode 7 is made by a sputtering method with a high film making speed, which results in a high productivity of the ohmic electrodes 7. The ohmic electrode 7 exhibits a low contact resistance equivalent to those of conventional ohmic electrodes made by using AuGe/Ni, and does not deteriorate characteristics of a semiconductor device using the ohmic electrode 7. Since the annealing temperature required for fabricating the ohmic electrode 7 is as low as 500°C to 600°C, undesired dispersion of impurities and re-distribution of impurities during the annealing can be prevented effectively.

Next explained is a second embodiment of the invention.

The second embodiment uses a multi-layered structure for fabricating the ohmic electrode as shown in Fig. 8 in lieu of the multi-layered structure for fabricating the ohmic electrode used in the first embodiment as shown in Fig. 4C. The multi-layered structure for fabricating the ohmic electrode shown in Fig. 8 is different from the structure of Fig. 4C in that the former does not include the W film 6. The other aspects of the second embodiment is the same as the first embodiment.

Also the second embodiment makes it possible to produce ohmic electrodes with good characteristics as those of the first embodiment with a high productivity.

Next explained is a third embodiment of the invention.

The third embodiment uses a multi-layered structure for fabricating the ohmic electrode as shown in Fig. 9 in lieu of the multi-layered structure for fabricating the ohmic electrode used in the first embodiment as shown in Fig. 4C. The multi-layered structure for fabricating the ohmic electrode shown in Fig. 9 is different from the structure of Fig. 1C in that the former uses an additional Al film 8 on the W film 6.

The third embodiment makes the Al film 8 on the W film 6, for example, by a sputtering method or an electron beam evaporation method after the W film 6 and other films are deposited in the same manner as shown in Fig. 4B. After that, by liftoff in the same manner as described with the first embodiment, a multi-layered structure for fabricating an ohmic electrode comprising the In_{0.7}Ga_{0.3}As layer 3, Ni film 4, WN film 5, W film 6 and Al film 8 is made on the ohmic electrode making portion and on the n⁺-type GaAs substrate 1. In this case, for easier liftoff, the resist pattern used for the liftoff may be made in two layers. If the resist pattern is a positive type resist, for example, the underlying resist pattern may be made of a more photosensitive resist.

According to the third embodiment, the uppermost Al film 8 of the multi-layered structure for fabricating the ohmic electrode contributes to reducing the sheet resistance of the ohmic electrode 7 made by using the multi-layered structure for fabricating the ohmic electrode. As a result, the ohmic electrode 7 can be used as IC wiring or capacitor electrode, which simplifies the wiring process of semiconductor devices and increases the flexibility in their design.

Explained below a fourth embodiment of the invention.

The fourth embodiment is directed to a process for manufacturing GaAs MESFETs which makes ohmic electrodes by using the ohmic electrode fabricating method according to the second embodiment and also makes gate electrodes simultaneously with the ohmic electrodes.

In the fourth embodiment, first, as shown in Fig. 10A, a semi-insulating GaAs substrate 9 is selectively ion-implanted with a donor impurity in a low concentration at the portion for making an n-type channel layer and in a high concentration at portions for making the source region and the drain region. Then, the structure is annealed at 700°C to 800°C, for example, to electrically activate the implanted impurity to provide the n-type channel layer 10, n₊-source region 11 and drain region 12.

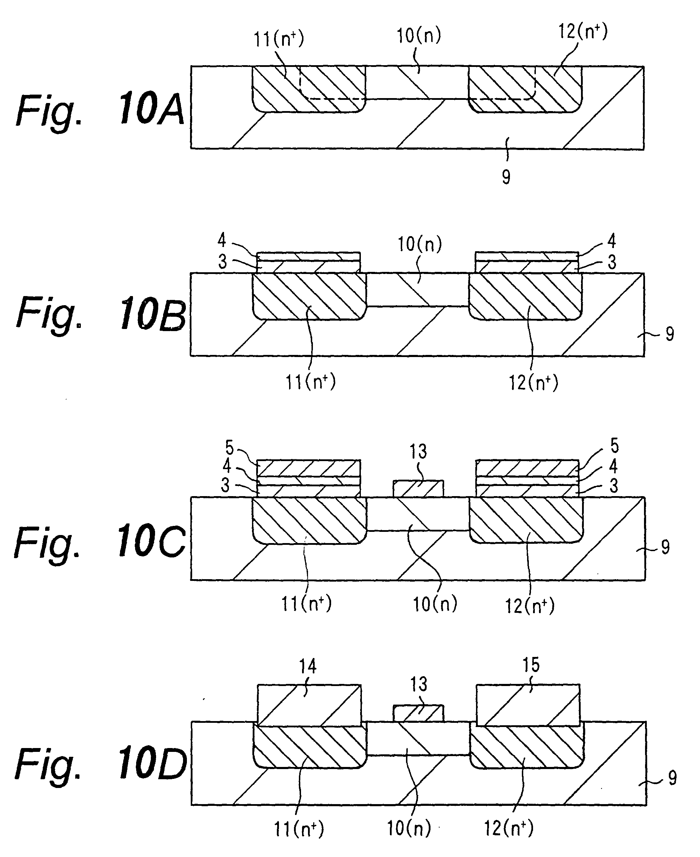

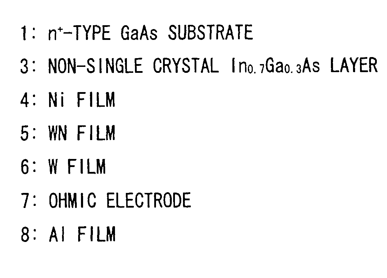

Next as shown in Fig. 10B, a multi-layered structure composed of the non-single crystal In_{0.7}Ga_{0.3}As layer 3 and the Ni film 4 is formed on the area for making the ohmic electrode by the lift-off method as referred to in the explanation of the first embodiment.

After that, a WN film is deposited on the entire surface by, for example, a sputtering method, a resist pattern (not shown) in the form corresponding to the gate electrode and the ohmic electrode to be made is formed on the WN film by a lithography method, the WN film is etched by, for example, a reactive ion etching (RIE) method using the resist pattern as a mask and using a CF₄/O₂ etching gas, and the resist pattern is removed thereafter. As a result, as shown in Fig. 10C, the structure obtained includes, on its electrode making area, multi-layered structures for fabricating ohmic electrodes composed of the non-single crystal In_{0.7}Ga_{0.3}As layer 3, Ni film 4 and WN film 5, and the gate electrode 13 composed of the WN film. Consequently, the WN film may be used to make wiring.

The product is then annealed at 500°C to 600°C by, for example, a RTA method. Thus, as shown in Fig. 10D, ohmic electrodes 14, 15 used as source and drain electrodes are formed in the same manner as explained with the first embodiment, and an expected GaAS MESFET is completed.

According to the fourth embodiment, the ohmic electrodes 14, 15 having good characteristics as source or drain electrodes can be made easily, and also the gate electrode 13 can be made simultaneously with formation of the multi-layered structures used for fabricating the ohmic electrodes 14, 15. As a result, the process for manufacturing GaAs MESFETs is simplified.

A fifth embodiment of the invention is described below.

When a semiconductor device requires both an ohmic electrode for an n-type III-V compound semiconductor and an ohmic electrode for a p-type III-V compound semiconductor, the fifth embodiment makes these ohmic electrodes simultaneously by using multi-layered structures for making ohmic electrodes.

More specifically, when a GaAs JFET, for example, is to be fabricated, a p⁻-type gate region, n-type source region and drain region are formed in a semi-insulating GaAs substrate, and multi-layered structures for fabricating ohmic electrodes like those of the first embodiment, for example, are made on the gate region, source region and drain region. After that, by annealing the product at, for example, 500°C to 600°C, ohmic electrodes are simultaneously formed on the gate region, source region and drain region.

For fabricating a heterojunction bipolar transistor (HBT) using III-V compound semiconductors, namely, n-type AlGaAs layer as the emitter layer, p-type GaAs as the base layer and n-type GaAs layer as the collector layer, which needs ohmic electrodes for the emitter, base and collector layers, these ohmic electrodes can be made simultaneously on the emitter, base and collector layers, respectively, by forming multi-layered structures for fabricating ohmic electrodes like those of the first embodiment, for example on the emitter, base and collector layers, and by annealing the structures at 500°C to 600°C.

Hereinabove, the invention has been described by way of specific examples; however, not being limited to these embodiments, the invention involves various modifications based on the technical concept of the invention.

For example, the Ni film 4 used in the first to fourth embodiments may be replaced by a Co film or an Al film.

Further, although the first to third embodiments make the multi-layered structure for fabricating ohmic electrodes by a lift-off method, it may be made by first sequentially stacking the respective layers of the multi-layered structure for fabricating ohmic electrodes on the entire surface of the n⁺-type GaAs substrate 1 and by subsequently patterning these layers into the form of ohmic electrodes by an etching method.

Furthermore, although the first to fourth embodiments have been explained as applying the invention to fabrication of ohmic electrodes onto the GaAs substrate, the invention may also be applied to fabrication of ohmic electrodes onto a GaAs layer made by epitaxial growth, for example.

Further, the invention may also be applied to fabrication of ohmic electrodes onto the source region and the drain region of a high electron mobility transistor (HEMT) using a III-V compound semiconductor, for example, AlGaAs/GaAs HEMT.

As described above, according to the invention, by annealing the multi-layered structure for fabricating an ohmic electrode, comprising a non-single crystal semiconductor layer and a film including at least a metal nitride film which are sequentially stacked on a III-V compound semiconductor body, ohmic electrodes having practically satisfactory characteristics for III-V compound semiconductors can readily be fabricated with a high productivity.

## Claims

1. A multi-layered structure for fabricating an ohmic electrode (7) comprising a semiconductor layer (3) and a film (4, 5, 6) including at least a metal nitride film which are sequentially stacked on a III-V compound semiconductor body (1),
**characterized in that**
said semiconductor layer (3) is a non-single crystal semiconductor layer.

2. A multi-layered structure for fabricating an ohmic electrode- according to claim 1, wherein said III-V compound semiconductor body (1) comprises GaAs, AlGaAs or InGaAs.

3. A multi-layered structure for fabricating an ohmic electrode according to claim 1, wherein said non-single crystal semiconductor layer (3) is a non-single crystal InₓGa₁₋ₓAs layer (0 < x ≤ 1).

4. A multi-layered structure for fabricating an ohmic electrode according to claim 1, wherein said film (4, 5, 6) comprises a metal film (4) and a metal nitride film (5) provided on said metal film (4).

5. A multi-layered structure for fabricating an ohmic electrode according to claim 4, wherein a refractory metal film (6) is further provided on said metal nitride film (5).

6. A multi-layered structure for fabricating an ohmic electrode according to claim 5, wherein a metal film for wiring is further provided on said refractory metal film (6).

7. A multi-layered structure for fabricating an ohmic electrode according to claim 4, wherein said metal film (4) is a Ni film, a Co film or an A1 film, and said metal nitride film (5) is a WN film, a WSiN film, a TaN film, a TaSiN film, a TiN film, a TiSiN film or a TiON film.

8. A multi-layered structure for fabricating an ohmic electrode according to claim 5, wherein said refractory metal film (6) is a W film, a Ta film or a Mo film.

9. A multi-layered structure for fabricating an ohmic electrode according to claim 1, wherein the energy barrier between said non-single crystal semiconductor layer (3) and said film (4, 5, 6) is lower than the energy barrier between said III-V compound semiconductor body (3) and said film (4, 5, 6).

10. A method of fabricating an ohmic electrode (7) by annealing the multi-layered structure according to claim 1.

11. A method of fabricating an ohmic electrode according to claim 10, wherein the annealing temperature of said multi-layered structure is 500 °C to 600 °C.

12. A method of fabricating an ohmic electrode according to claim 10, wherein said III-V compound semiconductor body (1) comprises GaAs, AlGaAs or InGaAs.

13. A method of fabricating an ohmic electrode according to claim 10, wherein said non-single crystal semiconductor layer (3) is a non-single crystal InₓGa₁₋ₓAs layer (0 < x ≤ 1).

14. A method of fabricating an ohmic electrode according to claim 10, wherein said film (4, 5, 6) comprises a metal film (4) and a metal nitride film (5) provided on said metal film (4).

15. A method of fabricating an ohmic electrode according to claim 14, wherein a refractory metal film (6) is further provided on said metal nitride film (5).

16. A method of fabricating an ohmic electrode according to claim 15, wherein a metal film for wiring is provided on said refractory metal film (6).

17. A method of fabricating an ohmic electrode according to claim 14, wherein said metal film (4) is a Ni film, a Co film or an Al film, and said metal nitride film (5) is a WN film, a WSiN film, a TaN film, a TaSiN film, a TiN film, a TiSiN film or a TiON film.

18. A method of fabricating an ohmic electrode according to claim 15, wherein said refractory metal film (6) is a W film, a Ta film or a Mo film.

19. A method of fabricating an ohmic electrode according to claim 10, wherein the energy barrier between said non-single crystal semiconductor layer (3) and said film (4, 5, 6) is lower than the energy barrier between said III-V compound semiconductor body (1) and said film (4, 5, 6).

## Patentansprüche

1. Mehrschichtige Struktur zum Herstellen einer ohmschen Elektrode (7) mit einer Halbleiterschicht (3) und einem Film (4, 5, 6) mit mindestens einem Metallnitridfilm, die aufeinanderfolgend auf einen Körper (1) eines III-V-Verbindungshalbleiters aufgestapelt sind;
**dadurch gekennzeichnet, dass**
- die Halbleiterschicht (3) eine nicht-einkristalline Halbleiterschicht ist.

2. Mehrschichtige Struktur zum Herstellen einer ohmschen Elektrode nach Anspruch 1, bei der der Körper (1) eines III-V-Verbindungshalbleiters aus GaAs, AlGaAs oder InGaAs besteht.

3. Mehrschichtige Struktur zum Herstellen einer ohmschen Elektrode nach Anspruch 1, bei der die nicht-einkristalline Halbleiterschicht (3) eine nicht-einkristalline InₓGa₁₋ₓAs-Schicht (0 < x ≤ 1) ist.

4. Mehrschichtige Struktur zum Herstellen einer ohmschen Elektrode nach Anspruch 1, bei der der Film (4, 5, 6) einen Metallfilm (4) und einen auf diesem vorhandenen Metallnitridfilm (5) enthält.

5. Mehrschichtige Struktur zum Herstellen einer ohmschen Elektrode nach Anspruch 4, bei der auf dem Metallnitridfilm (5) ferner ein Film (6) aus einem hochschmelzenden Metall vorhanden ist.

6. Mehrschichtige Struktur zum Herstellen einer ohmschen Elektrode nach Anspruch 5, bei der auf dem Film (6) aus einem hochschmelzenden Metall ferner ein Metallfilm für Leiterbahnen vorhanden ist.

7. Mehrschichtige Struktur zum Herstellen einer ohmschen Elektrode nach Anspruch 4, bei der der Metallfilm (4) ein Ni-, ein Co- oder ein A1-Film ist und der Metallnitridfilm (5) ein WN-, ein WSiN-, ein TaN-, ein Ta-SiN-, ein TiN-, ein TiSiN- oder ein TiON-Film ist.

8. Mehrschichtige Struktur zum Herstellen einer ohmschen Elektrode nach Anspruch 5, bei der der Film (6) aus einem hochschmelzenden Metall ein W-, ein Ta- oder ein Mo-Film ist.

9. Mehrschichtige Struktur zum Herstellen einer ohmschen Elektrode nach Anspruch 1, bei der die Energiebarriere zwischen der nicht-einkristallinen Halbleiterschicht (3) und dem Film (4, 5, 6) niedriger als die Energiebarriere zwischen dem Körper (3) eines III-V-Verbindungshalbleiters und dem Film (4, 5, 6) ist.

10. Verfahren zum Herstellen einer ohmschen Elektrode (7) durch Tempern der mehrschichtigen Struktur gemäß Anspruch 1.

11. Verfahren zum Herstellen einer ohmschen Elektrode nach Anspruch 10, bei dem die Temperungstemperatur für die mehrschichtige Struktur 500°C bis 600°C beträgt.

12. Verfahren zum Herstellen einer ohmschen Elektrode nach Anspruch 10, bei dem der Körper (1) eines III-V-Verbindungshalbleiters aus GaAs, AlGaAs oder InGaAs besteht.

13. Verfahren zum Herstellen einer ohmschen Elektrode nach Anspruch 10, bei dem die nicht-einkristalline Halbleiterschicht (3) eine nicht-einkristalline InₓGa₁₋ₓAs-Schicht (0 < x ≤ 1) ist.

14. Verfahren zum Herstellen einer ohmschen Elektrode nach Anspruch 10, bei dem der Film (4, 5, 6) einen Metallfilm (4) und einen auf diesem vorhandenen Metallnitridfilm (5) enthält.

15. Verfahren zum Herstellen einer ohmschen Elektrode nach Anspruch 14, bei dem auf dem Metallnitridfilm (5) ferner ein Film (6) auf einem hochschmelzenden Metall vorhanden ist.

16. Verfahren zum Herstellen einer ohmschen Elektrode nach Anspruch 15, bei dem auf dem Film (6) aus einem hochschmelzenden Metall ferner ein Metallfilm für Leiterbahnen vorhanden ist.

17. Verfahren zum Herstellen einer ohmschen Elektrode nach Anspruch 14, bei dem der Metallfilm (4) ein Ni-, ein Co- oder ein Al-Film ist und der Metallnitridfilm (5) ein WN-, ein WSiN-, ein TaN-, ein Ta-SiN-, ein TiN-, ein TiSiN- oder ein TiON-Film ist.

18. Verfahren zum Herstellen einer ohmschen Elektrode nach Anspruch 15, bei dem der Film (6) aus einem hochschmelzenden Metall ein W-, ein Ta- oder ein Mo-Film ist.

19. Verfahren zum Herstellen einer ohmschen Elektrode nach Anspruch 10, bei dem die Energiebarriere zwischen der nicht-einkristallinen Halbleiterschicht (3) und dem Film (4, 5, 6) niedriger als die Energiebarriere zwischen dem Körper (3) eines III-V-Verbindungshalbleiters und dem Film (4, 5, 6) ist.

## Revendications

1. Structure multicouche pour fabriquer une électrode ohmique (7) comprenant une couche semiconductrice (3) et un film (4, 5, 6) incluant au moins un film en nitrure de métal qui sont empilés de façon séquentielle sur un corps semiconducteur composite III-V (1),
**caractérisé en ce que** :
ladite couche semiconductrice (3)est une couche semiconductrice non monocristalline.

2. Structure multicouche pour fabriquer une électrode ohmique selon la revendication 1, dans laquelle ledit corps semiconducteur composite III-V (1) comprend GaAs, AlGaAs ou InGaAs.

3. Structure multicouche pour fabriquer une électrode ohmique selon la revendication 1, dans laquelle ladite couche semiconductrice non monocristalline (3) est une couche en InₓGa₁₋ₓAs (0 < x ≤ 1) non monocristalline.

4. Structure multicouche pour fabriquer une électrode ohmique selon la revendication 1, dans laquelle ledit film (4, 5, 6) comprend un film métallique (4) et un film en nitrure de métal (5) qui est prévu sur ledit en métal (4).

5. Structure multicouche pour fabriquer une électrode ohmique selon la revendication 4, dans laquelle un film en métal réfractaire (6) est en outre prévu sur ledit film en nitrure de métal (5).

6. Structure multicouche pour fabriquer une électrode ohmique selon la revendication 5, dans laquelle un film en métal pour un câblage est en outre prévu sur ledit film en métal réfractaire (6).

7. Structure multicouche pour fabriquer un électrode ohmique selon la revendication 4, dans laquelle ledit film en métal (4) est un film en Ni, un film en Co ou un film en Al et ledit film en nitrure de métal (5) est un film en WN, un film en WSiN, un film en TaN, un film en TaSiN, un film en TiN, un film en TiSiN ou un film en TiON.

8. Structure multicouche pour fabriquer une électrode ohmique selon la revendication 5, dans laquelle ledit film en métal réfractaire (6) est un film W, un film en Ta ou un film en Mo.

9. Structure multicouche pour fabriquer une électrode ohmique selon la revendication 1, dans laquelle la barrière d'énergie entre ladite couche semiconductrice non monocristalline (3) et ledit film (4, 5, 6) est inférieure à la barrière d'énergie entre ledit corps semiconducteur composite III-V (3) et ledit film (4, 5, 6).

10. Procédé de fabrication d'une électrode ohmique (7) en soumettant à un recuit la structure multicouche selon la revendication 1.

11. Procédé de fabrication d'une électrode ohmique selon la revendication 10, dans lequel la température de recuit de ladite structure multicouche est comprise entre 500°C et 600°C.

12. Procédé de fabrication d'une électrode ohmique selon la revendication 10, dans lequel ledit corps semiconducteur composite III-V (1) comprend GaAs, AlGaAs ou InGaAs.

13. Procédé de fabrication d'une électrode ohmique selon la revendication 10, dans lequel ladite couche semiconductrice non monocristalline (3) est une couche en InₓGaₓ₋₁As (0 ≤ x ≤ 1) non monocristalline.

14. Procédé de fabrication d'une électrode ohmique selon la revendication 10, dans lequel ledit film (4, 5, 6) comprend un film en métal (4) et un film en nitrure de métal (5) qui est prévu sur ledit en métal (4).

15. Procédé de fabrication d'une électrode ohmique selon la revendication 14, dans lequel en métal réfractaire (6) est en outre prévu sur ledit film en nitrure de métal (5).

16. Procédé de fabrication d'une électrode ohmique selon revendication 15, dans lequel un film en métal pour un câblage est prévu sur ledit film en métal réfractaire (6).

17. Procédé de fabrication d'une électrode ohmique selon la revendication 14, dans lequel ledit film en métal (4) est un film en Ni, un film en Co ou un film en Al et ledit film en nitrure de métal (5) est un film WN, un film WSiN, un film en TaN, un film en TaSiN, un film en TiN, un film en TiSiN ou un film en TiON.

18. Procédé de fabrication d'une électrode ohmique selon la revendication 15, dans lequel ledit film en métal réfractaire (6) est un film en W, un fil en Ta ou un film Mo.

19. Procédé de fabrication d'une électrode ohmique selon la revendication 10, dans lequel la barrière d'énergie entre ladite couche semiconductrice non monocristalline et ledit film (4, 5, 6) est inférieur à la barrière d'énergie entre ledit corps semiconducteur III-V (1) et ledit film (4, 5, 6).
